Europäisches Patentamt

European Patent Office

Office européen des brevets

11 Veroffentlichungsnummer **0 003 480**
B1

# EUROPÄISCHE PATENTSCHRIFT

45 Veroffentlichungstag der Patentschrift
02.06.82

51 Int. Cl. **G 06 F 11/10, H 04 L 1/10**

21 Anmeldenummer 78101791.8

22 Anmeldetag 20.12.78

54 Schaltungsanordnung zum Umwandeln von Binärinformationen mittels Kontrollbits.

30 Priorität 30.12.77 DE 2759106

43 Veroffentlichungstag der Anmeldung
22.08.79 Patentblatt 79/17

45 Bekanntmachung des Hinweises auf die Patenterteilung
02.06.82 Patentblatt 82/22

84 Benannte Vertragsstaaten
CH GB IT NL SE

56 Entgegenhaltungen
US-A-3 319 223
US-A-3 798 597
IBM TECHNICAL DISCLOSURE BULLETIN, Band 15, Nr. 4, September 1972, New York, Seiten 1314, 1315,
BOUDREAU: »Parallel CRC Generation for multi-length characters«
IBM TECHNICAL DISCLOSURE BULLETIN, Band 18, Nr. 10, März 1976, New York, USA,
DUVOCHEL: »Block check character determination in table look UP procedure«

73 Patentinhaber SIEMENS AKTIENGESELLSCHAFT
Berlin und München, Postfach 22 02 61,
D-8000 München 22 (DE)

72 Erfinder Herkert. Hans, Kurzweg 3,
D-8021 Hohenschäftlarn (DE)

PROCEEDINGS OF THE FALL JOINT COMPUTER CONFERENCE, 16—18 November 1971, New York, USA, Seiten 1—8,
AFIPS MAHOLICK: »A universal cyclic division circuit«

EP 0 003 480 B1

## Schaltungsanordnung zum Umwandeln von Binärinformationen mittels Kontrollbits

Die Erfindung bezieht sich auf eine Schaltungsanordnung zum Codieren oder Decodieren, mit einer Einrichtung zur Bildung einer Zahl von Kontrollbits in Abhängigkeit von mehrere Stellen aufweisenden Binärinformationen unter Verwendung eines zyklischen Codes, wobei mittels eines Codierers ein Informationspolynom durch ein Generatorpolynom geteilt wird, und der sich bei der Teilung ergebende Rest das Ergebnis der Codierung bzw. Decodierung ist.

Eine derartige Schaltungsanordnung ist z. B. aus dem Buch von J. Swoboda, »Codierung zur Fehlerkorrektur und Fehlererkennung«, Seite 108, bekannt.

Zur Codierung und Decodierung von Impulstelegrammen werden häufig zyklische Codes verwendet. Derartige Codes bieten bei einer bestimmten Anzahl von Kontrollschritten bzw. bei vorgegebener Redundanz die größtmögliche Wahrscheinlichkeit der Fehlererkennung. In einem zyklischen Code ist ein Telegrammpolynom dann gültig, wenn es durch ein Generatorpolynom ohne Rest teilbar ist. Interessant ist also immer der Divisionsrest, nicht aber das Divisionsergebnis. Jedes Telegrammpolynom ist daher auch ein Vielfaches eines Generatorpolynoms. Ebenso muß das Telegrammpolynom einen größeren Grad haben als das Generatorpolynom, sonst ist es nicht mehr durch das Generatorpolynom teilbar.

Polynome mit einem Grad kleiner als das Generatorpolynom bilden die Restpolynome oder Reste oder Restpotenzen des Generatorpolynoms. Aus ihnen werden beim Senden eines Telegramms die Kontrollschritte gebildet. Beim Senden eines Telegramms wird an die Nachrichtenbits ein solches Kontrollbitmuster angehängt, daß das Telegrammpolynom wiederum ohne Rest durch das Generatorpolynom teilbar ist. Die Wahl des Generatorpolynoms bestimmt die Codedistanz und damit die Wahrscheinlichkeit der Fehlererkennung.

Es ist bekannt, zur Division eines Telegrammpolynoms durch ein Generatorpolynom ein rückgekoppeltes Schieberegister zu verwenden. Die Anzahl der Zellen des Schieberegisters ist so groß, wie der Grad des Generatorpolynoms und die Rückkopplungsschleifen werden dem Aufbau des Generatorpolynoms entsprechend über Exklusiv-ODER-Glieder ausgeführt. Ein Takt schiebt das Telegrammpolynom durch das Schieberegister, wobei es durch die Rückkopplungsschleifen durch das Generatorpolynom dividiert wird. Bei Telegrammende steht der Divisionsrest in den Zellen des Schieberegisters. Ist der Divisionsrest in den Zellen logisch 0, so ist das Telegramm gültig.

Beim Aussenden eines Telegramms bildet der Divisionsrest in den Zellen die Kontrollschritte, die an die Nachrichtenbits des Telegramms angehängt werden.

Durch die Möglichkeit, über ein geeignetes rückgekoppeltes Schieberegister den Divisionsrest zu ermitteln, der bei der Division eines Telegrammpolynoms durch ein Generatorpolynom entsteht, haben die zyklischen Codes eine besondere Bedeutung gewonnen.

Die Codierung und Decodierung zyklischer Codes hat jedoch z. B. bei schneller paralleler Datenübertragung ihre Grenzen oder bei Datenverarbeitungseinrichtungen, bei denen serielle Daten durch Ein-Ausgabe-Interfaces empfangen oder ausgesendet, innerhalb der Verarbeitungseinrichtung jedoch parallel verarbeitet werden.

Aufgabe der Erfindung ist es daher, eine Schaltungsanordnung der vorstehend näher bezeichneten Art derart auszubilden, daß sie sich auf möglichst einfache Weise an die Erfordernisse einer parallelen Datenverarbeitung anpassen läßt.

Überlegungen im Rahmen der Erfindung haben ergeben, daß bei der Lösung dieser Aufgabe die Kontrollbits vorteilhaft durch mehrere aufeinanderfolgende Divisionsvorgänge gewonnen werden können.

Gemäß der Erfindung wird die Schaltungsanordnung derart ausgebildet, daß der Codierer bzw. Decodierer eine Einrichtung zum Aufteilen der Binärinformation in mehrere Wörter gleicher Bitzahl, einen Modulo-2-Addierer und einen Teilcodierer enthält, und daß der Modulo-2-Addierer mit einem Eingang an die Einrichtung und mit dem anderen Eingang an den Teilcodierer angeschlossen ist, und daß der Teilcodierer die ihm wortweise parallel zugeführte Information durch das Generatorpolynom teilt und an seinem Ausgang sich aus der Teilung ergebenden Rest parallel abgibt, und daß der eine Eingang des Modulo-2-Addierers mit den von der Einrichtung abgegebenen Wörtern parallel beaufschlagt ist, und daß dem anderen Eingang jeweils der Divisionsrest des vorhergehenden Wortes zugeführt ist, wobei zum höchstwertigen Wort anstelle des Divisionsrestes ein Wort 0 addiert wird, und daß die dem Teilcodierer zugeführte Information die durch die Modulo-2-Addition gewonnene Information ist.

Dabei kann die Binärinformation eine Paralleloder Serieninformation, insbesondere ein Impulstelegramm sein. Die Binärinformation wird in mehrere gleich lange Teile zerlegt, die aus mehreren Bits bestehen. Der erste Teil wird durch das Generatorpolynom dividiert, der Divisionsrest auf den nächsten Informationsteil mod-2 addiert usw., bis die Binärinformation verarbeitet ist.

Durch diese Maßnahmen ergibt sich der Vorteil, daß sich die Schaltungsanordnung ohne aufwendige Schaltungsänderungen an die Erfordernisse der parallelen Datenverarbeitung anpassen läßt. Außerdem läßt sich bei paralleler Datenverarbeitung eine besonders hohe Verarbeitungsgeschwindigkeit erzielen.

In weiterer Ausgestaltung der Erfindung wird die Schaltungsanordnung derartig ausgebildet, daß der Teilcodierer ein rückgekoppeltes, durch eine Einrichtung zur Ablaufsteuerung rücksetzbares und taktsteuerbares Schieberegister ist, in das die durch Modulo-2-Addition gewonnene Information als Parallelinformation eingebbar ist.

Eine besonders hohe Geschwindigkeit läßt sich für die Codierung dadurch erzielen, daß der Teilcodierer ein Speicher mit wahlfreiem Zugriff ist, der mit seinen Adresseneingängen am Ausgang des Modulo-2-Addierers liegt und in dem je Adresse die sich durch Teilung der Adresse durch das Generatorpolynom ergebende Information gespeichert ist.

Zweckmäßigerweise ist der Speicher mit wahlfreiem Zugriff ein nur lesbarer Speicher bzw. ein sog. ROM. Weiterhin kann man dem Modulo-2-Addierer zweckmäßigerweise ein durch die Einrichtung zur Ablaufsteuerung steuerbares Register nachschalten.

In Weiterbildung der Erfindung wird die Schaltungsanordnung derart ausgebildet, daß die Binärinformation dem Modulo-2-Addierer bitweise zugeführt wird, und daß die freien Eingänge des Modulo-2-Addierers an den logischen Zustand 0 gelegt sind.

Die Erfindung wird anhand der in den Figuren gezeigten Ausführungsbeispiele näher erläutert. Es zeigt

Fig. 1 eine Schaltungsanordnung zur Telegrammcodierung und Decodierung mit einem Schieberegister und

Fig. 2 eine Schaltungsanordnung zur Telegrammcodierung und Decodierung mit einem ROM.

Das Impulstelegramm bzw. Telegramm wird als Polynom dargestellt, wobei der letzte Telegrammschritt den Grad 0 erhält.

### Beispiel

Telegramm
1 0 0 1 1

Polynom
$$1 \cdot x^4 + 0 \cdot x^3 + 0 \cdot x^2 + 1 \cdot x^1 + 1 \cdot x^0 = x^4 + x + 1$$

Für die Variable x darf dabei nicht irgendeine Zahl aus der Menge aller Zahlen eingesetzt werden, sondern ein Bitmuster aus der Menge der Restpotenzen. Das Auffinden geeigneter Generatorpolynome für eine bestimmte Codedistanz ist Aufgabe der linearen Algebra. Das Generatorpolynom wird hier als gegeben vorausgesetzt. Für die folgenden Erklärungen wird immer das Generatorpolynom $x^4 + x + 1$ verwendet.

Die Koeffizienten des Polynoms nehmen die beiden Werte 0 und 1 ein. Zwei Polynome werden addiert, indem man die Variablen x mit gleichem Exponenten addiert. Die Addition der Koeffizienten folgt dem mod-2-Gesetz.

Ferner läßt sich das Polynom durch Multiplikation mit x nach links verschieben. Diese Multiplikation mit x entspricht einem Schiebetakt.

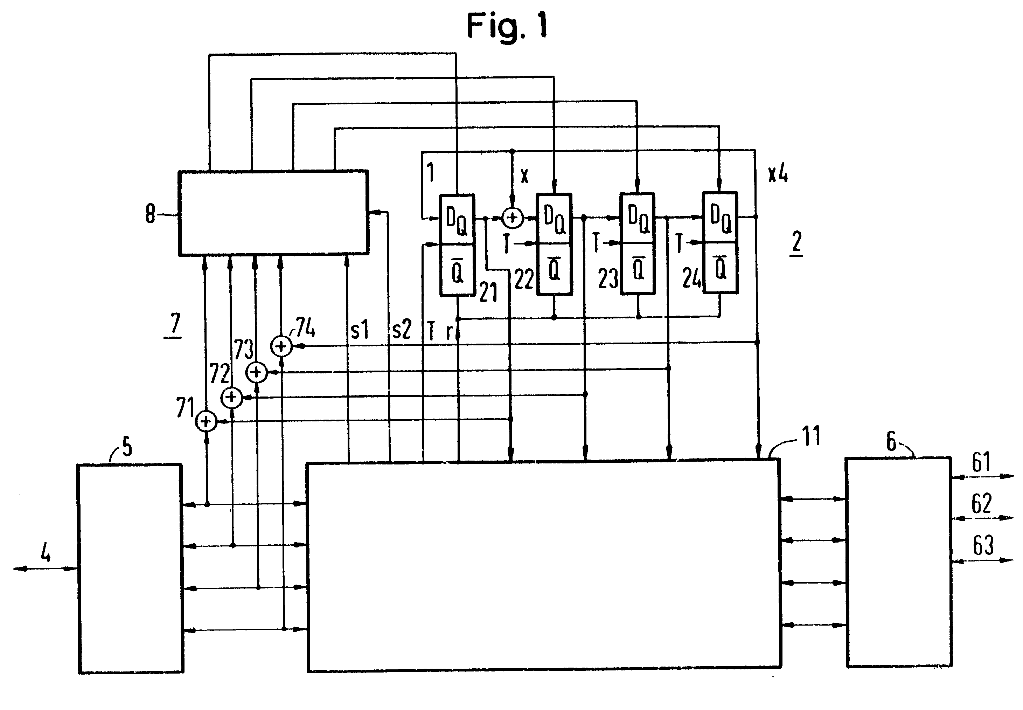

Fig. 1 zeigt eine Schaltungsanordnung für eine Codierung und Decodierung bei paralleler Telegrammverarbeitung mit einem Register.

Bei dieser Schaltungsanordnung ist die Fernleitung 4 an ein Serien-Parallel-Interface bzw. den Serien-Parallel-Umsetzer 5 angeschlossen. Die über die Fernleitung 4 seriell übertragene Binärinformation wird mit Hilfe des Serien-Parallel-Umsetzers 5 in eine Parallelinformation umgesetzt, die aus Wörtern zu je 4 Bit besteht. Die Wörter werden einerseits einem in der Einrichtung 11 enthaltenen, in der Figur nicht dargestellten Telegrammzwischenspeicher und andererseits dem Modulo-2-Addierer 7 zugeführt. Der Modulo-2-Addierer 7 besteht aus den vier Exklusiv-Oder-Gliedern 71 bis 74, die jeweils für eine Stelle des Wortes eine Modulo-2-Addition durchführen. Die anderen Eingänge des Modulo-2-Addierers 7 sind mit dem Ausgang des Schieberegisters 2 verbunden.

Die Ausgänge der Exklusiv-Oder-Glieder des Modulo-2-Addierers 7 sind an das Register 8 geführt, das von der Einrichtung 11, die zur Ablaufsteuerung dient und vorzugsweise durch einen Microprozessor gebildet ist, mit Strobeimpulsen S1 und S2 gesteuert.

Der Ausgang des Registers 8 ist an die Eingänge der D-Flip-Flops 21 bis 24 geführt. Diese D-Flip-Flops 21 bis 24 sind als rückgekoppeltes Schieberegister geschaltet und bilden einen Teilcodierer, der die vom Register 8 abgegebene Parallelinformation durch das Generatorpolynom $x^4 + x + 1$ teilt. Die Takteingänge der D-Flip-Flops werden von der Einrichtung 11 mit einem Takt T, die Rücksetzeingänge mit Rücksetzimpulsen r beaufschlagt.

An den Ausgängen der D-Flip-Flops 21 bis 24 liegt der sich bei der Teilung durch das Generatorpolynom ergebende Rest als Parallelinformation an. Diese Information wird einerseits an die Einrichtung 11 und andererseits an einen der beiden Eingänge des Modulo-2-Addierers geführt.

An die Einrichtung 11 ist ferner das Parallel-Interface 6 angeschlossen, das einen Anschluß 61 für ein Datensichtgerät, einen Anschluß 62 für einen Drucker und einen Anschluß 63 für Anzeigelampen usw. aufweist.

An den Q-Ausgängen der im Polynom-Schieberegister enthaltenen D-Flip-Flops 21 bis 24 steht der Divisionsrest am Ende des Telegrammdurchlaufs zur Verfügung, d. h. an den $\overline{Q}$-Ausgängen der invertierte Divisionsrest. Der Divisionsrest muß beim Empfang eines Telegramms 0 sein. Beim Senden des Telegramms bildet er die Kontrollschritte.

Für den Fall, daß ein Impulstelegramm empfangen wird, setzt die Einrichtung 11 mit einem Rücksetzimpuls r das als Teildecodierer dienende Polynom-Schieberegister 2 in die Ruhelage. Das Telegramm, seriell von der Fernleitung 4 kommend, wird 4-Bit-weise an die Einrichtung 11 und an das Register 2 gegeben Die am Ausgang des Polynom-Schieberegisters 2 abgegebene Information wird jeweils mit einem Wort des 4-Bit-weise ankommenden Telegramms mod 2 addiert. Das sich dabei ergebende weitere Wort wird durch einen Stroboimpuls s1 in das Register 8 geladen. Ein zweiter Stroboimpuls s2 lädt den Inhalt des Registers 32 in das Polynom-Schieberegister 2. Die folgenden 4 Takte T dividieren diesen Telegrammteil durch das Generatorpolynom. Der sich bei der Division ergebende Rest wird mit den nächsten 4 Bits des Telegramms mit Hilfe des Mod-2-Addierers 7 nach dem mod-2-Gesetz addiert und über das Register 8 in das Polynom-Schieberegister 2 geladen. Vier Takte dividieren auch diesen Telegrammteil und so fort, bis die letzten 4 Telegrammbits einlaufen. Sie müssen, mit dem Divisionsrest aus dem Polynom-Schieberegister mod 2 addiert, das Wort 0 0 0 0 ergeben. Ist der Divisionsrest nach den letzten 4 Telegrammbits 0 0 0 0, dann verarbeitet die Einrichtung 11 das Telegramm weiter. Andernfalls wird das Telegramm verworfen oder eine Fehlerkorrektur vorgenommen.

Die Telegrammdivision läßt sich folgendermaßen darstellen.

Telegramm:

0 1 1 0    1 0 1 0    0 0 1 0    0 1 1 0

wird zerlegt in

```
0110    0000
plus    1010    0000
plus            0010    0000
plus                    0110
```

Der erste Telegrammteil wird durch das Generatorpolynom dividiert und der Rest dem nächsten Telegrammteil mod 2 aufaddiert. Es wird wieder dividiert und der Rest dem nächsten Telegrammteil aufaddiert. Der Rest des vorletzten Telegrammteils muß mod 2 addiert auf den letzten Telegrammteil den Rest 0 0 0 0 ergeben.

Bei dem genannten Beispiel ändert sich der Inhalt des Schieberegisters 2 während der Datenverarbeitung wie folgt

| | Schieberegister-Stufe (gezählt von links nach rechts gemäß Fig. 1) | | | |
| --- | --- | --- | --- | --- |
| | 1 | 2 | 3 | 4 |
| 1. Telegrammteil | 0 | 1 | 1 | 0 |
| nach Schritt | | | | |
| 1 | 0 | 0 | 1 | 1 |
| 2 | 1 | 1 | 0 | 1 |

| | Schieberegister-Stufe (gezählt von links nach rechts gemäß Fig. 1) | | | |
| --- | --- | --- | --- | --- |
| | 1 | 2 | 3 | 4 |
| nach Schritt | | | | |
| 3 | 1 | 0 | 1 | 0 |
| 4 | 0 | 1 | 0 | 1 |
| mod-2-Addition mit (2. Telegrammteil) | 1 | 0 | 1 | 0 |
| | 1 | 1 | 1 | 1 |
| | | | | u.s.w. |

Beim Senden des Telegramms setzt die Einrichtung 11 mit dem Rücksetzimpuls das Polynom-Schieberegister 2 in die Ruhelage. Das Parallelinterface 6 liefert die Telegrammnachrichten und den Anreiz zum Aussenden eines Telegramms. Die Einrichtung 11 gibt das Telegramm 4-Bit-weise an das Serien-Parallel-Interface 5 und an die Codiereinrichtung. Sind alle Nachrichtenbits ausgesendet, dann hängt die Einrichtung 11 den Divisionsrest am Ausgang des Polynom-Schieberegisters als Kontrollbits an die Nachrichtenbits an und beendet damit das Telegramm. Im übrigen läuft der Codierungsvorgang wie bei einer empfangenen Binärinformation ab.

Im beschriebenen Beispiel stimmt die Stellenzahl des Sicherungsanhanges mit der Bitzahl der Wörter überein. Gegebenenfalls können die Wörter mehr Bits enthalten. In diesem Fall ist dem rückgekoppelten Schieberegister ein Parallel-Serien-Umsetzer für die weiteren Bits vorzuschalten.

Haben die Wörter weniger Bits als der Sicherungsanhang, so werden die freien Eingänge des Modulo-2-Addierers an den logischen Zustand 0 gelegt.

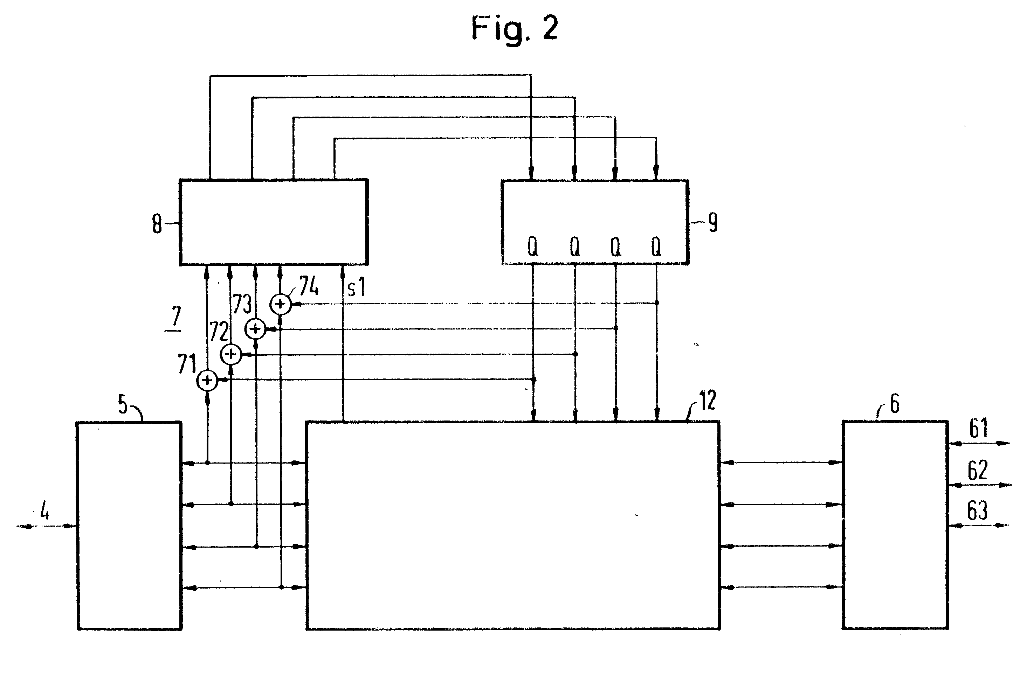

Fig. 2 zeigt eine Schaltungsanordnung für Codierung und Decodierung bei paralleler Telegrammverarbeitung mit Register und ROM. Diese Schaltungseinrichtung unterscheidet sich von der nach Fig. 1 dadurch, daß anstelle des Polynomschieberegisters 2 ein Speicher 9 mit wahlfreiem Zugriff vorgesehen ist. Der Speicher 9 ist ein Lesespeicher bzw. ROM. Der Adresseneingang des Speichers 9 ist an den Ausgang des Registers 8 angeschlossen. Der Ausgang des Speichers 9 ist mit seinen Q-Anschlüssen einerseits an je einen Eingang der im Modulo-2-Addierer enthaltenen Exklusiv-Oder-Gatter 71 bis 74 geführt. Außerdem ist an den Ausgang des Speichers 9 auch die Einrichtung 12 zur Ablaufsteuerung angeschlossen.

Ein weiterer Unterschied zu der in Fig. 1 gezeigten Schaltungsanordnung besteht noch darin, daß von der Einrichtung 12 zum Register 8 nur eine einzige Leitung für einen Strobeimpuls S1 erforderlich ist.

Da jedes in das Polynom-Schieberegister 2 nach Fig. 2 eingeschriebene Bitmuster nach der Polynomdivision ein definiertes anderes Bitmuster ergibt, kann das Schieberegister 2 in vorteilhafter Weise durch einen Speicher 9 mit wahlfreiem Zugriff, der insbesondere ein ROM ist, ersetzt werden. Diese Schaltungsanordnung erlaubt eine besonders schnelle Telegrammverarbeitung, weil der Speicher 9 bzw. das ROM sofort das Ergebnis liefert und nicht erst nach mehreren Schiebetakten wie das Polynom-Schieberegister.

Die Schaltungsanordnung läßt sich vorteilhaft in Einrichtungen zur Datenübertragung verwenden, insbesondere zur Codierung oder Decodierung von Fernwirktelegrammen. Fernwirktelegramme können bei der Übertragung von einer Fernwirkstation zur anderen über Fernleitungen durch Störspannungen verfälscht werden. Der Telegrammsender fügt deshalb zweckmäßigerweise mehrere Kontrollschritte an das Telegramm, deren Bitmuster von dem Bitmuster der Nachrichtenbits abhängig ist: Das Telegramm wird codiert.

Der Telegrammempfänger kontrolliert die Nachrichtenbits und die Kontrollbits und erkennt daraus mit einer definierten Wahrscheinlichkeit eine Verfälschung: Das Telegramm wird decodiert.

Bei der Ausbildung der Einrichtung 11 bzw. 12 als Microprozessor kann diese zweckmäßigerweise für weitere Steuerungen, z. B. zum zyklischen Aufrufen von Fernwirkstationen zusätzlich ausgenutzt werden.

## Patentansprüche

1. Schaltungsanordnung zum Codieren oder Decodieren, mit einer Einrichtung zur Bildung einer Zahl von Kontrollbits in Abhängigkeit von mehrere Stellen aufweisenden Binärinformationen unter Verwendung eines zyklischen, Codes, wobei mittels eines Codierers ein Informationspolynom durch ein Generatorpolynom geteilt wird und der sich bei der Teilung ergebende Rest das Ergebnis der Codierung bzw. Decodierung ist, dadurch gekennzeichnet, daß der Codierer bzw. Decodierer eine Einrichtung (5) zum Aufteilen der Binärinformation in mehrere Wörter gleicher Bitzahl, einen Modulo-2-Addierer (7) und einen Teilcodierer enthält, und daß der Modulo-2-Addierer mit einem Eingang an die Einrichtung (5) und mit dem anderen Eingang an den Teilcodierer angeschlossen ist, und daß der Teilcodierer die ihm wortweise parallel zugeführte Information durch das Generatorpolynom teilt und an seinem Ausgang den sich aus der Teilung ergebenden Rest parallel abgibt, und daß der eine Eingang des Modulo-2-Addierers mit den von der Einrichtung (5) abgegebenen Wörtern parallel beaufschlagt ist, und daß dem anderen Eingang jeweils der Divisionsrest des vorhergehenden Wortes zugeführt ist, wobei zum höchstwertigen Wort anstelle des Divisionsrestes ein Wort 0 addiert wird, und daß die dem Teilcodierer zugeführte Information die durch die Modulo-2-Addition gewonnene Information ist.

2. Schaltungsanordnung nach Anspruch 1, dadurch gekennzeichnet, daß der Teilcodierer ein rückgekoppeltes, durch eine Einrichtung (12) zur Ablaufsteuerung rücksetzbares und taktsteuerbares Schieberegister (2) ist, in das die durch Modulo-2-Addition gewonnene Information als Parallelinformation eingebbar ist (Fig. 1).

3. Schaltungsanordnung nach Anspruch 2, dadurch gekennzeichnet, daß der Teilcodierer ein Speicher (9) mit wahlfreiem Zugriff ist, der mit seinen Adresseneingängen am Ausgang des Modulo-2-Addierers (7) liegt und in den je Adresse die sich durch Teilung der Adresse durch das Generatorpolynom ergebende Information gespeichert ist (Fig. 2).

4. Schaltungsanordnung nach Anspruch 3, dadurch gekennzeichnet, daß der Speicher (9) mit wahlfreiem Zugriff ein nur lesbarer Speicher ist.

5. Schaltungsanordnung nach einem der Ansprüche 2 bis 4, dadurch gekennzeichnet, daß dem Modulo-2 Addierer (7) ein durch die Einrichtung (11, 12) zur Ablaufsteuerung steuerbares Register (8) nachgeschaltet ist.

6. Schaltungsanordnung nach Anspruch 3, dadurch gekennzeichnet, daß die Binärinformation dem Modulo-2-Addierer bitweise zugeführt wird, und daß die nicht mit der Binärinformation beaufschlagten Eingänge des Modulo-2-Addierers an den logischen Zustand 0 gelegt sind.

## Claims

1. Circuit arrangement for coding or decoding, comprising a device which serves to form a number of control bits in dependence upon items of binary information which have a plurality of digits, employing a cyclic code, wherein an information polynominal is divided by a generator polynominal by means of a coder and the remainder arising from the division is the result of the coding or decoding, characterised in that the coder or decoder comprises a device (5) for dividing the binary information into a plurality of words of the same bit number, a modulo-2-adder (7) and a dividing coder, and that the modulo-2-adder is connected to the device (5) by means of one input and to the dividing coder by means of the other input, and that the dividing coder divides the information, which is fed to the dividing coder in parallel word by word, by the generator polynominal and emits the remainder arising from the division in parallel at its output, and that the one input of the modulo-2-adder is fed in parallel with the words emitted by the device (5), and that the other input is respectively fed with the division remainder of the preceding word, a word 0 instead of the division remainder being added to the left-most word, and that the information fed to the dividing coder ist obtained by means of the modulo-2-addition.

2. Circuit arrangement as claimed in claim 1, characterised in that the dividing coder is a feedback shift register (2) which is pulse-controllable and can be reset by a device (12) for sequence control and into which the information obtained by means of the modulo-2-addition can be inserted as parallel information (Fig. 1).

3. Circuit arrangement as claimed in claim 2, characterised in that the dividing coder is a store (9) with random access whose address inputs adjoin the output of the modulo-2-adder (7) and in which the information obtained as a result of the division of the address by the generator polynominal is stored for each address (Fig. 2).

4. Circuit arrangement as claimed in claim 3, characterised in that the store (9) with random access is a read only store.

5. Circuit arrangement as claimed in one of the claims 2 to 4, characterised in that the modulo-2-adder (7) is followed by a register (8) which can be controlled by the device (11, 12) for the sequence control.

6. Circuit arrangement as claimed in claim 3, characterised in that the binary information is supplied to the modulo-2-adder bit by bit and that the inputs of the modulo-2-adder which are not fed with the binary information are connected to the logic state 0.

**Revendications**

1. Montage pour coder et décoder, du type comportant un dispositif pour former un nombre de bits de commande en fonction d'informations comprenant plusieurs chiffres, avec mise en œuvre d'un code cyclique, un polynôme d'information étant divisé, à l'aide d'un codeur, par un polynôme de générateur et le reste résultant de la division étant le résultat du codage ou du décodage, caractérisé par le fait que le codeur ou le décodeur comprend un dispositif (5) pour répartir l'information binaire en plusieurs mots de même nombre de bits, un additionneur modulo-2 et un codeur partiel, et que l'additionneur modulo-2 est relié par une entrée au dispositif (5) et par l'autre entrée au codeur partiel, et que le codeur partiel divise par le polynôme de générateur l'information qui lui est appliqué en parallèle et mot par mot et émet à sa sortie le reste qui résulte de la division, et que ladite première entrée de l'additionneur modulo-2 est chargé, en parallèle, avec les mots émis par le dispositif (5) et qu'à ladite autre entrée est appliqué le reste de la division du mot précédent, au mot de poids le plus élevé étant ajouté un mot 0 à la place du reste de la division et que l'information appliquée au codeur partiel est l'information obtenue par l'addition modulo-2.

2. Montage selon la revendication 1, caractérisé par le fait que le codeur partiel est un registre à décalage (2) couplé en réaction, susceptible d'être commandé par des signaux de cadence et d'être remis à l'état initial par un dispositif pour la commande séquentielle (12), registre dans lequel est introduite, sous la forme d'une information parallèle, l'information obtenue par l'addition modulo-2.

3. Montage selon la revendication 2, caractérisé par le fait que le codeur partiel est une mémoire (9) à accès aléatoire, dont les entrées d'adresses sont reliées à la sortie de l'additionneur modulo-2 (7), et dans lequel est mémorisée, par adresse, l'information qui résulte de la division de l'adresse par le polynôme de générateur.

4. Montage selon la revendication 3, caractérisé par le fait que la mémoire (9) à accès aléatoire est une mémoire morte.

5. Montage selon l'une des revendications 2 à 4, caractérisé par le fait qu'en aval de l'additionneur modulo-2 (7) est monté un registre susceptible d'être commandé par le dispositif (11, 12) pour la commande séquentielle.

6. Montage selon la revendication 3, caractérisé par le fait que l'information binaire est appliquée bit par bit à l'additionneur modulo-2 et que les entrées de l'additionneur modulo-2 qui ne sont pas chargées par l'information binaire sont placees à l'état logique 0.

Fig. 1

# Fig. 2